Europäisches Patentamt

European Patent Office

Office européen des brevets

(19)

(11) Publication number: **0 353 041**
A2

# (12) EUROPEAN PATENT APPLICATION

(21) Application number: 89307583.8

(22) Date of filing: 26.07.89

(51) Int. Cl.⁵: **G 06 F 7/49**
G 06 F 7/72, H 03 M 7/12,
H 04 L 9/30

(30) Priority: 26.07.88 GB 8817766

(43) Date of publication of application:
31.01.90 Bulletin 90/05

(84) Designated Contracting States:
AT BE CH DE ES FR GB GR IT LI LU NL SE

(71) Applicant: THORN EMI plc
4 Tenterden Street
London W1A 2AY (GB)

(72) Inventor: Derome, Michael Fernand Alexander
1 Playfair Mansions Queens Club Gardens
London, W14 9TR (GB)

Green, Ian MacDonald
"Westwood" High Street
Buckie Banffshire (GB)

(74) Representative: Fleming, Ian Alexander et al
THORN EMI Patents Limited The Quadrangle Westmount
Centre Uxbridge Road
Hayes Middlesex, UB4 0HB (GB)

The title of the invention has been amended (Guidelines for Examination in the EPO, A-III, 7.3).

(54) **Signal processing apparatus and method using modified signed digit arithmetic.**

(57) A high speed signal processing apparatus for processing long numbers includes a modified signed digit adder 12 having a plurality of adder cells. An input means is provided for inputting binary signals and binary coded modified signed digit format signals to the adder 12 for effecting simultaneous addition and or subtraction of the binary signals and the binary coded modified signed digit format signals. The apparatus includes means for performing modulo multiplication of the inputted signals and a converter 18 for converting the results to normal binary.

FIG 3

EP 0 353 041 A2

**Description**

## SIGNAL PROCESSING

The present invention relates to equipment for, and a method of, processing signals, and in particular but not exclusively in applications concerned with encryption techniques.

RSA encryption is a well known, completely secure method of coding blocks of data. The encryption itself, which involves the exponentiation of one very large number by another modulo a third, can be reduced to multiple modulo multiplications each of which can be reduced to many modulo additions of large numbers. However, a very large number of additions are required and, for example 500,000 additions of 512 bit numbers might be needed to encrypt or decrypt 64 bytes of data.

A known problem with fast adders is the time taken to propagate the carry. Look-ahead carry systems have been described which reduce this problem, but the carry propogation time still constitutes a serious limitation to the practical speed, and hence the viability in this application, of fast adders when used to perform multiple additions of numbers with very many bits.

There is a known form of redundant ternary (3-state) arithmetic, called modified signed-digit (MSD) arithmetic, in which each N "trit" (ternary digit) number represents an $N+1$ bit binary number. MSD arithmetic allows additions of indeterminate length without the carry problem arising. Most binary numbers can be represented in more than one way in MSD code. Whereas in binary a number can be expressed only as the sum of powers of 2, in MSD a number can be expressed as sums and differences of powers of two and in several different ways. For example, the number "7" can be expressed in binary only as $4 + 2 + 1$ (namely 0111), but in MSD it can be expressed as $4 + 2 + 1$ (namely $0, +1, +1 +1$) or 8 - 1 (namely $+1, 0, 0, -1$) or $8 - 4 + 2 + 1$ (namely $+1, -1, +1, +1$), and so on. Hence very fast addition of long numbers can be achieved as the trits of the numbers can be summed using parallel processing.

However an MSD adder requires ternary logic elements which are much more complex than, binary logic elements and therefore much more expensive.

The operation of representing a binary number in MSD is straightforward, but conversion from MSD to a binary representation involves a ripple carry. Thus, although two binary numbers can be converted to MSD and added without a carry delay, the delay reappers in the conversion back to binary.

The present invention seeks to provide a method and apparatus enabling a plurality of arithmetic operations to be achieved in parallel, thereby providing substantially faster processing of the signals.

Accordingly, there is provided signal processing apparatus comprising a modified signed digit adder having a plurality of adder cells and input means to input binary signals and binary coded modified signed digit format signals to the adder for effecting simultaneous addition and or subtraction of the binary signals and the binary coded modified signed digit format signals.

More specifically, in a modulo multiplier wherein each cycle involves not only the addition of two numbers but also the subtraction of the modulus, the present invention enables that addition and subtraction to be performed simultaneously.

The present invention is especially, but not solely, applicable to encryption (for example RSA encryption) processing of signals; clearly it can be used in the encryption and/or decryption stages of such processing. Thus, by using the present invention, encryption/decryption techniques can be substantially faster (for example up to twenty times faster) than existing systems, which makes it feasible to encrypt speech in real time, this conventionally being technically impossible.

In a preferred embodiment of the present invention, for an MSD adder cell with four input leads $A_1$, $A_2$, $B_1$, and $B_2$ (wherein conventionally the bit pair of the coded MSD number A would be applied to $A_1$ and $A_2$ and the corresponding bit pair of number X to $B_1$ and $B_2$), the equipment comprises means to apply a bit of the binary number X to $B_1$ and 0 to $B_2$ to produce the result $A+X$, means to apply a bit of the binary number Y to $B_2$ and 0 to $B_1$ to produce the result A-Y, and means to apply the bit of number X to $B_1$ and the bit of number Y to $B_2$ to produce the result $A+X-Y$. In all cases, the number A and the output sum are in coded MSD.

This ability to add two numbers and subtract a third number simultaneously in the same adder is particularly advantageous in modulus arithmetic. When successive additions of two numbers are carried out the number of bits in the intermediate sum increases and, since this is used in the next addition, the bit processing capability of the adder would also have to increase to avoid system overflow e.g. multiplication of two 512 bit numbers would require a 1024-stage adder instead of a 512-stage adder unless steps are taken to prevent this. Thus, preferably the magnitude of the intermediate sum in a modulo multiplication is examined and, if the intermediate sum exceeds a predetermined value, a fixed number M (the modulus), or a multiple thereof, is subtracted from the intermediate sum. This modulus correction to the intermediate sum ensure that the number of bits required to be processed does not exceed the capability of the adder.

preferably, the intermediate sum in modulo multiplication is fed back to the adder input uncorrected such that, modulus correction, if required is carried out as part of the next addition, eliminating the separate step of modulus subtraction in conventional techniques and so reducing the calculation time.

The present invention also provides a method of processing signals comprising affording binary coded modified signed digit format signs and binary coded signals to a modified signed digit adder cell thereby to effect simultaneous addition and or substraction of the afforded signals.

In a preferred embodiment, the method comprises applying a conventional binary bit of a number X to an input of an MSD adder cell $B_1$ and 0 to an input $B_2$ to produce the result $A+X$, and applying the binary bit of a number Y to $B_2$ and 0 to $B_1$ to produce the result A-Y, and applying the bit of number X to $B_1$ and the bit of number X to $B_2$ to produce the result of $A+X-Y$.

To carry out the MSD to binary conversion after each addition would involve an unacceptable increase in the processing time. Also, whereas a range of magnitudes of a binary number can be approximately determined from a few most significant bits, (MSB), the same is not true of an MSD number since the less significant bits may be negative. The magnitude of the MSD sum can therefore be estimated approximately from a few MSD, albeit with greater difficulty.

An object of another aspect of the present invention is to overcome this problem.

Thus, another aspect of the present invention provides equipment for use in the processing of signals, the equipment comprising means to effect adding of binary-coded signals in modified-signed-digit format and of binary-coded signals not in that format, and, for applying modulus correction to the sum obtained thereby, means to effect subtraction of the modulus number or a multiple thereof when the sum exceeds the modulus.

Preferably the subtraction means comprises means to utilise large multiples of the modulus to effect the correction. In this way the range of values of the sum before modulus correction is necessary is much larger, and an approximation of the value is sufficient.

Thus, in order to prevent the number of bits of the results of the successive additions from becoming progressively larger, the modulus number or a multiple thereof is subtracted from the sum whenever the sum exceeds the modulus. Whereas this is easily done in binary multiplication the subtraction of the modulus in MSD arithmetic is far more difficult. The problem arises in the comparator which is required to determine in what range of values the sum signals should be in order to determine whether the modulus per se or a multiple of the modulus is to be subtracted from the intermediate sum. In the binary case this is easily done by examining a few of the most significant bits e.g. if the bit representing $2^N$ is a "1", the value of the number must be equal to or greater than $2^N$. With an MSD number, however, if the trit representing $2^N$ +1, the value of the number may be equal to or greater than $2^N$, but it may also be less than $2^N$, since some of the less significant trits may be negative. Therefore to determine whether the sum lies above or below a predetermined value, many more trits have to be examined than with a binary number. One solution to this problem would be to convert the sum from MSD to binary before comparing, but the conversion involves delays and since the conversion would have to be carried out after each addition, the cumulative delay during a multiplication would be considerable.

The present invention provides, therefore, a technique for performing the modulus correction without a need to to convert the MSD sum to binary.

In order that the invention may more readily be understood, a description is now given, by way of example only, reference being made to the accompanying drawings, in which:-

Figure 1 shows logic circuits for fabricating an MSD adder cell for use in signal processing apparatus in accordance with the present invention;

Figure 2 shows a MSD to binary signal conversion circuit;

Figure 3 shows hardware architecture for a modulo multiplier equipment embodying principles of the present invention;

Figures 4 to 7 show an implementation of modulus correction architecture for use in equipment embodying the present invention.

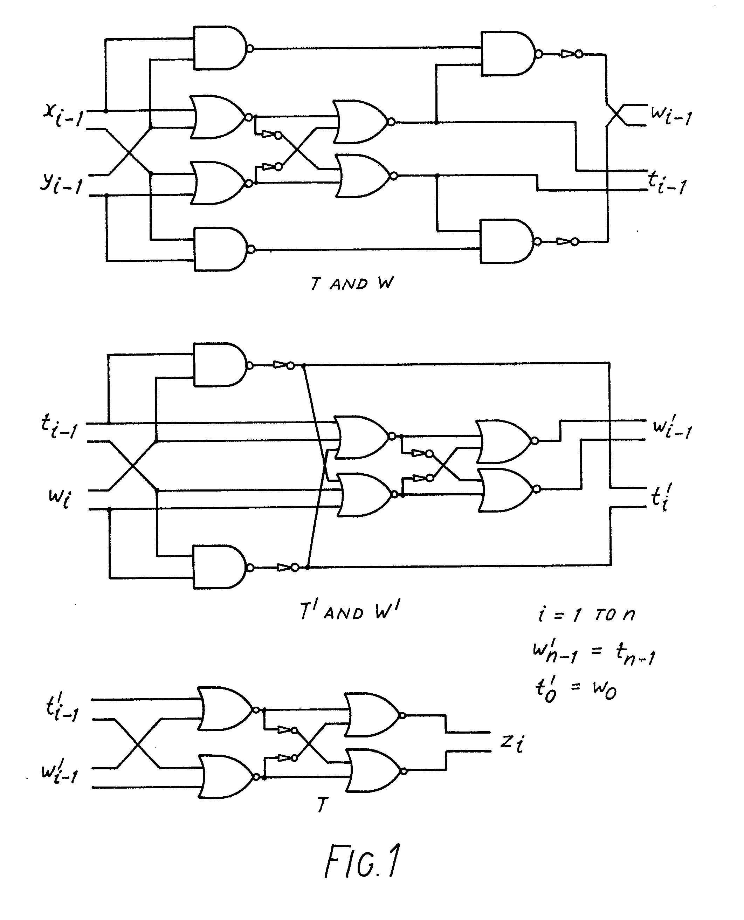

A modified signed digit (MSD) adder consists of a number of MSD adder cells. MSD arithmetic permits very fast additions of numbers of indeterminate length as the trits of one number can be summed with their correspondingly significant trits of another number in parallel. The MSD adder usually comprises a number of adder cells corresponding to the number of trits in the numbers to be summed. An MSD adder cell consists of four different types of logic elements, commonly known as transfer and weight elements and usually designated by the letters T, W, T$^1$ and W$^1$. If the trits of the MSD numbers are coded in binary format such as, for example, by causing the binary codes 10, 00, 01 to represent the trits 1, 0 and -1, the MSD adder cells may be configured using binary logic elements for the elements T, W, T$^1$ and W$^1$, as shown in Figure 1. As only three out of the four available combinations of the two bit binary codes are used to represent the MSD trits, the fourth combination, 11 in the example referred to above, is redundant or unused.

This unused binary combination, in the present invention, is used to simplify the binary circuitry of the MSD adder.

An MSD adder cell usually includes two inputs, each input comprising a pair of input lines one positive and the other negative. When two MSD numbers are required to be added, the correspondingly significant trits of the numbers are entered into the T (transfer trit) and W (weight trit) elements of the adder. The resulting trits are passed via the second stage elements T$^1$ and W$^1$ and final stage elements T to provide the summed output in MSD format.

In the present invention, an efficient binary implementation of an MSD adder has been realised. One of the four binary combinations used to represent the MSD trits, 11 in the example above, is unused so the "don't care" logic states within the adder cells eases the problem of representing the MSD adder cell truth table in terms of binary gates. Also, the W and T elements of the adder cells have common inputs so that each utilises, to an extent, the logic functions carried out in the other. Figure 1 shows the binary logic circuits to implement T, W, T$^1$ and W$^1$ for binary coded MSD numbers using the binary codes 10, 00 and 01 to represent the MSD trits -1, 0 and +1 respectively. It has been realised in the present invention that the MSD adder can accept, on one pair of input lines, an MSD format number and, on a second pair of input lines an input in binary format and by selectively applying bits of the binary format input, which represents a number, the MSD adder enables one binary number to be added to the MSD number and, additionally and at the same time, the subtraction of a second binary number. The simultaneous addition and subtraction of two binary numbers from an MSD number is particular useful as it allows addition and modulus subtraction to be carried out simultaneously.

Since the two sets of binary inputs representing one MSD number have weightings of 1 and -1, if a binary number is applied to the set of 1 inputs of the adder cells while zero is applied to the set of -1 inputs of the adder cells, the result is that the binary number is added to the MSD number applied to the adder. If instead the binary number is applied to the set of -1 inputs, while zero is applied to the set of 1 inputs, the binary number is subtracted from the MSD number. If two separate binary numbers X and Y are applied to the 1 and -1 sets of inputs respectively, and an MSD number T applied to the second MSD input, the output of the adder is the function X - Y + T, provided that when corresponding bits of X and Y are both 1 the MSD input to which they are applied treats the combination as zero.

By feeding two binary numbers P and Q into the sets of "1" inputs of an MSD adder and two other binary numbers R and S into the sets of "-1" inputs of the MSD adder it is also possible to perform the parallel operation of P + Q - R - S.

Normally "11" is a combination which does not arise; either the logic of Figure 1 is modified to include this new state, or external gates can be added to set the input bits to zero when the same bits of the binary numbers X and Y are 1. Implementing this change should be straightforward for one skilled in the art and will not, therefore, be described.

Although in the principles described above binary signals are applied to the inputs of the MSD adder cells, the output from the adder will be in MSD fcrmat. If the MSD adder with binary processing is combined, therefore, with an MSD to binary converter, a signal processor may be realised which is particularly suitable for RSA encoding or decoding.

In MSD to binary conversion, the MSD input is, in practice represented by two binary lines which allow four combinations of 0 and 1. In the example shown, the binary codes 00, 01, 10 are chosen, respectively, to represent the MSD trits 0, 1, and -1, one combination, namely 11, remaining unused. This unused combination, denoted X, is utilised in the MSD to binary conversion, although it should be realised that the same result can be achieved less efficiently by introducing an extra signal line. The following sequence of operation does not assume a particular choice of binary code for the MSD number, although any binary realisation requires binary codes to be allocated. The following operation is performed on each trit in turn, starting with the penultimate least significant trit and proceeding to the most significant trit:

IF the current trit is 0
AND the trit to the right is -1 or X (the unused code)
THEN replace the current trit with the unused code X
ELSE leave the current trit as it is

In stage two the operations are parallel. A binary bit (0 or 1) is derived from the four trit codes 0, 1, -1 and X of the current trit position and those of the next trit right. For the purpose of explaining the operation, the number to the right of the rightmost trit should be considered zero. (The rightmost trit cannot be X as it is the only one never changed by stage 1). The rules are as follows:

(1) IF the current trit is 1
THEN IF the next right trit is -1 or X
THEN the output bit is 0
ELSE the output bit is 1
(2) IF the current trit is 0
THEN the output bit is 0
(3) IF the current trit is X
THEN the output bit is 1
(4) IF the current trit is -1
THEN IF the next right trit is X or -1
THEN the output bit is 0
ELSE the output bit is 1.

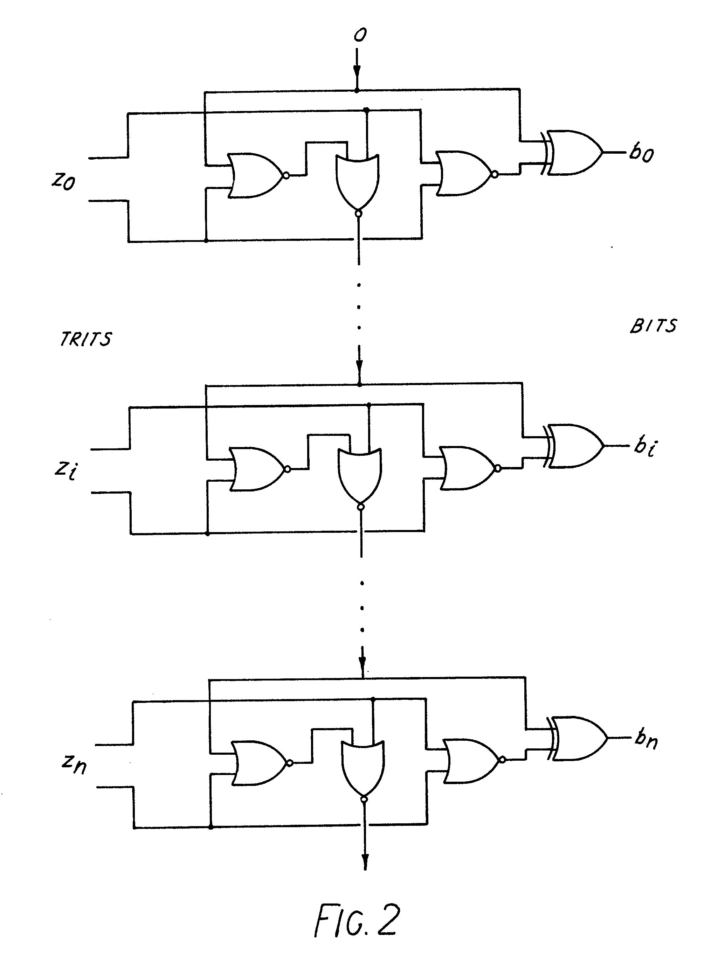

Figure 2 shows a realisation of the MSD converter, using standard logic gate graphical symbols, based on the above sequence of operation when the codes for 0, 1, -1, X are chosen to be 00, 01, 10 and 11 respectively.

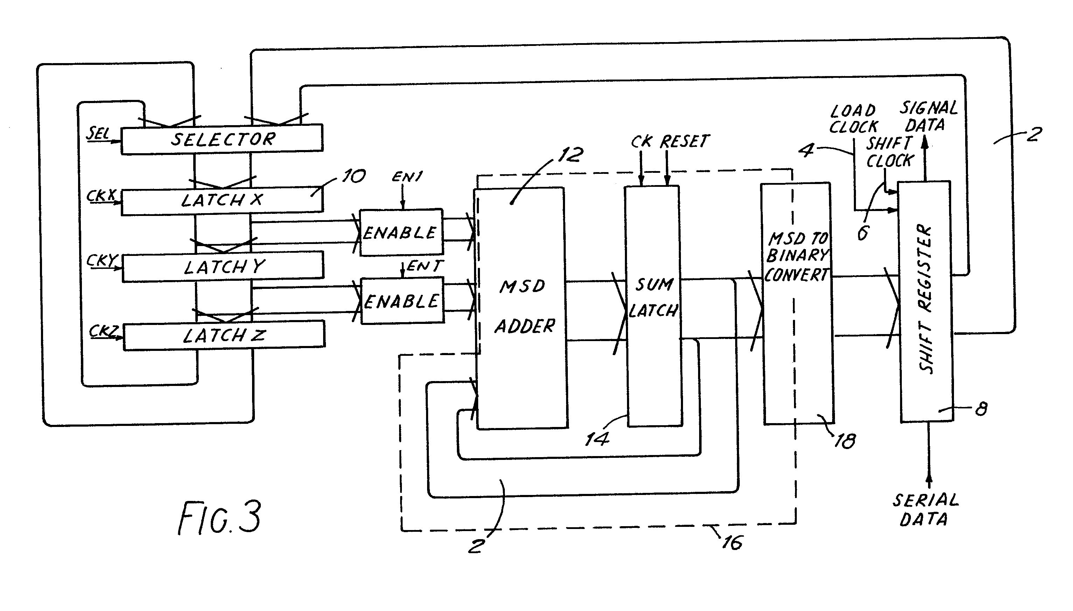

Figure 3 shows a further improvement to the signal processor which performs the modulo multiplication A*B modulo M which can then be used to resolve the RSA encryption algorithm, which is of the form $A^B$ modulo M. In Figure 3 all the data buses 2 are N bits or trits wide, where N is the length of the RSA numbers to be resolved. In practice this length might be 520 bits, and a few more would be allowed for overflow. Some control lines such as clock lines 4, 6 have been shown, but the controller itself is not shown as this is assumed to be known to one skilled in this art.

The shift register 8 is used to clock in input numbers, to clock out results, and to turn numbers into serial streams as required for multiplying by the shift and add method. The latches 10 are controlled so that each one holds the appropriate number required for each multiply. The numbers in the XYZ latches are not required to change during the multiply.

In general, since the RSA sequence of operations requires the evaluation of A to the power B modulo M, numbers A and M are, preferably, loaded into the circuit before the start of the evaluation, while B is fed bit by bit to the controller during the evaluation, as the controller requests. For each bit of B the controller (not shown) causes the architecture of Figure 3 to perform one or two multiplications. Thus the overall evaluation is reduced, by known means, to a number of multiplications; each multiply reduced in turn to a number of additions.

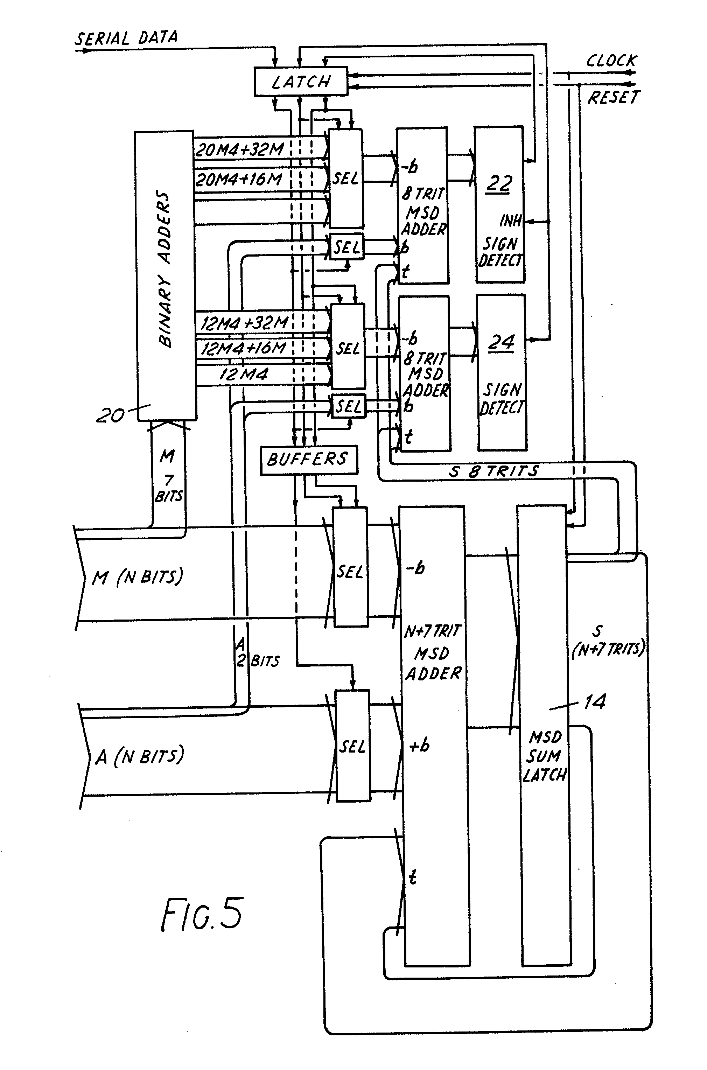

The modulo addition takes place in the MSD adder 12, with the serial stream from the shift register 8 controlling whether the sum is shifted or shifted and added to perform modulo multiplication. At the same time the modulus subtractions are required, when the sum exceeds the modulus. All the operations required are performed in the MSD adder, and are selected by enabling either or both the + and - adder binary inputs. Modulus subtraction is controlled using overflow lines on the sum latch 14 shown in Figure 5.

Those components contained within the dotted line 16 represent MSD arithmetic, using two binary lines for each trit. Other components shown are conventional binary. During each multiply, fast operation is ensured by the use of the MSD adder 12; its output is used only in MSD form. After the multiply is complete, the result is taken fro the MSD adder 12 to an MSD binary converter 18. The conversion is a relatively slow operation, but since it is needed only at the end of each multiply, it does not significantly slow the overall computation.

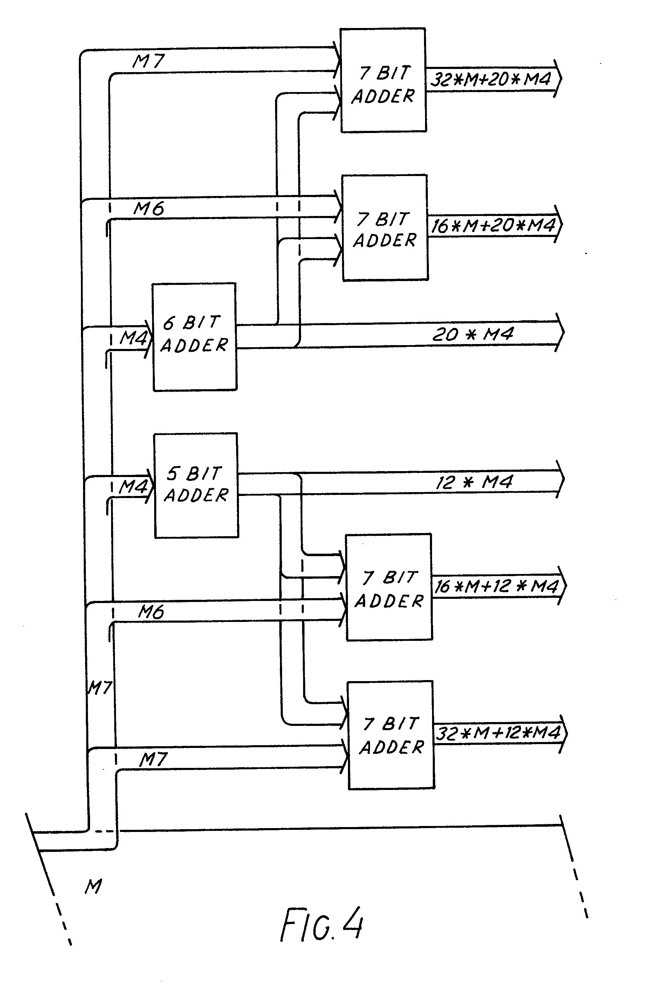

Modulus correction is implemented in the apparatus shown in Figures 4 to 7, the modulus correction being carried out as part of the MSD shift/add cycle, without significantly increasing the shift/add cycle time. Only three possible corrections have to be subtracted, and one of these is zero, since that allows the hardware to be simplified. The two non-zero corrections are easily derived from the modulus, commonly known as M. The correction is computed using the MSD intermediate sum S, thus avoiding the time-consuming MSD to binary conversion.

One of the corrections is a power of two times the modulus, such as 8 or 16 times, and the second correction is twice the first one, so that both numbers have the same bit pattern as the modulus, and can be derived from it by simply shifting bits.

The advantage of using a multiple of the modulus M, rather than the modulus itself, is that the sum can lie within a much larger range of numbers before correction, and that adequate correction can be made even when the sum cannot be compared accurately with other integers, as will be the case when using MSD arithmetic. Also the relative indeterminacy introduced, when adding number A to form the sum $2S + A$, is much less if S is considerably greater than A.

The modulus correction to be used can be determined from a selected consecutive number of the most significant bits of the modulus M, together with a selected consecutive number of the most significant trits of the MSD sum S. Modulus correction does not mean the correction which reduces the sum to the range 0 to M-1, but rather the correction that leaves the sum in a range of numbers from which the next stage of the multiply can take place without delay. The correction hardware is relatively simple when compared with the main MSD adder, which may for example be 500 trits long.

An example of the implementation of the modulus correction sequence of operations is:-

```
IF        S6 <  12*M4   THEN   subtract O     from S

ELSE IF   S6 <  20*M4   THEN   subtract 8*M   from S

     ELSE              .       subtract 16*M  from S
```

where M is the modulus, S is the uncorrected sum, M4 is the first 4 bits of the modulus M followed by zeros, and S6 is the first 6 trits of the sum S followed by zeros.

The shift and add function takes the old sum S, and forms the new sum 2S and $2S + A$, depending on whether the multiplying bit is zero or one. Therefore, instead of subtracting a multiple of M at the end of one cycle, and thereby prolonging the cycle time, twice the multiple of M is subtracted during the next cycle. The MSD adder has a spare binary subtract input. However, comparing S6 with 12M4 and 20M4 will still add to the cycle time.

The comparison of S6 with 12M4 and 20M4 may be done at the same time as the main addition, utilising the top few bits or trits only of the numbers S, M, and A. If instead of subtracting 16m, say, as is done in the main adder, 16M + 12M4 is subtracted, then instead of having to compare the resulting sum with 12M4, it may be compared with zero, which is a relatively simple and therefore rapid operation. Similarly the result of comparing S6 with 20M4 is readily computed in parallel with the main addition. The top few bits/trits suffice for these subsidiary computations because the MSD adder does not propagate carries.

As a result, the shift and add sum, the computation of the modulus correction, and the subtraction of that correction, can all be done in the same time as the shift-add operation on its own i.e. within a single clock cycle of the processor. With state of the art CMOS technology this might, for example, be 25 nanoseconds.

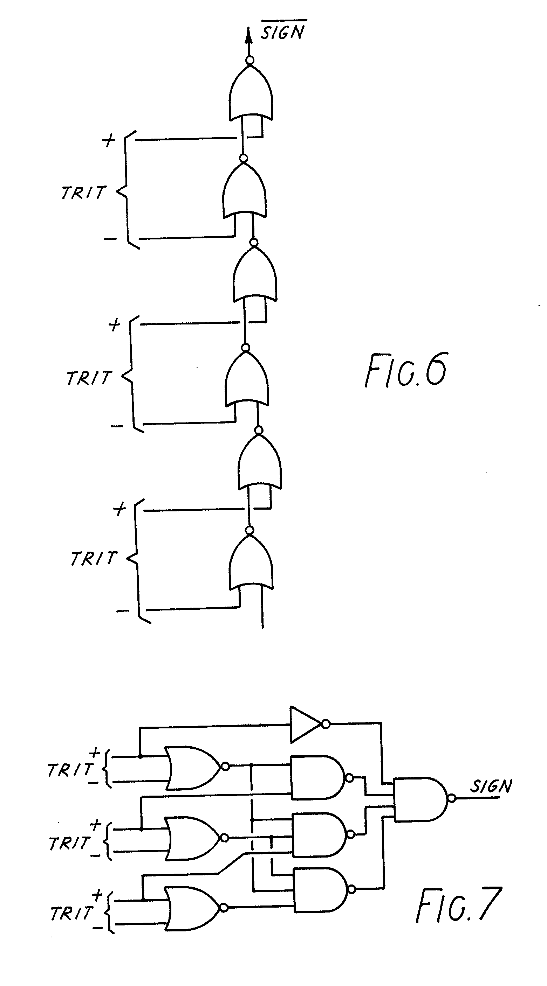

Figures 4 and 5 show the hardware for determining the modulus and applying it to the main adder 12, figure 4 showing, in greater detail, the configuration of the binary adders 20 illustrated in Figure 5. Figures 6 and 7 show suitable logic for the sign detect blocks 22, 24 illustrated in Figure 5. When all the calculations have been completed it is necessary to convert the final output from MSD to binary, suitable logic for performing the conversion being shown in Figure 7.

Although the present invention has been described with respect to specific embodiments it should be realised that modifications may be made whilst remaining within the scope of the invention. For example, any multiple of the modulus may be adopted for effecting modulus correction. Furthermore, other configurations of logic gates for the MSD adder cell elements and sign detect circuits will be evident to those skilled in the art. Additionally, other algorithms may be realised for operation of the MSD to binary converter and or the modulos correction circuitry.

## Claims

1. Signal processing apparatus comprising a modified signed digit adder having a plurality of adder cells and input means to input binary signals and binary coded modified signed digit format signals to the adder for effecting simultaneous addition and or subtraction of the binary signals and the binary code modified signed digit format signals.

2. Signal processing apparatus according to Claim 1 wherein the modified signed digit adder cells comprise a plurality of inputs, each including a pair of input lines, for receiving the binary signals and the binary coded modified signed digit format signals, the input means being arranged to provide bit pairs of the binary coded modified signed digit format signals representing the modified signed digit ternary digits 1, 0 and -1, to a first pair of input lines and to selectively provide a bit from a bit pair of the binary signals to one and or both input lines of a further pair thereby to effect the simultaneous addition and or subtraction of the binary signals and the binary coded modified signed digit signals.

3. Signal processing apparatus according to Claim 2 wherein the input means is arranged to provide a bit of the binary signal to a first input line of the further pair and a binary zero to the other input line of the further pair thereby to effect simultaneous addition of the provided binary signal and binary coded modified signed digit format signal.

4. Signal processing apparatus according to Claim 2 wherein the input means is arranged to provide a binary zero to the first input line of the further pair and a bit of the binary signal to the other input line of the further pair thereby to effect simultaneous subtraction of the provided binary signal from the binary coded modified signed digit format signal.

5. Signal processing apparatus according to Claim 2 wherein the input means is arranged to provide a bit of a first binary signal to the first input line of the further pair and a bit of a second binary signal to the further input line of the further pair, and wherein the adder cell is arranged to process the bit combination applied to the input lines of the further pair as binary zero when the bit combination comprises the redundant bit pair not used to represent a ternary digit of the binary coded modified signed digit signals, thereby to effect simultaneously, addition of one of the provided binary signals to, and subtraction of the other provided binary signal from, the binary coded modified signed digit signal.

6. Signal processing apparatus according to any one of the preceding claims wherein the binary signals represent binary numbers in modified signed digit format.

7. Signal processing apparatus according to any one of the preceding claims comprising conversion means arranged to receive output signals from the adder cells in modified signed digit format and for converting the received output signals into binary signals.

8. Signal processing apparatus according to Claim 7, wherein the conversion means is arranged to operate in accordance with the following algorithm, commencing with the penultimate least significant ternary digit of the output signals from the adder cells and proceeding to the most significant ternary digit of the output signals from the adder cells, the algorithm comprising, in a first serial stage of conversion
IF the current ternary digit is 0
AND the adjacent less significant ternary digit is -1 or X, where X is the redundant bit pair not used to represent a ternary digit,
THEN replace the current ternary digit with X
ELSE leave the current ternary digit unchanged;
and in a second parallel stage of conversion,
IF the current ternary digit is 1
THEN IF the next less significant ternary digit is -1 or X THEN the output bit is 0
ELSE the output bit is 1
or
IF the current ternary digit is 0
THEN the output bit is 0
or
IF the current ternary digit is X
THEN the output bit is 1
or
IF the current ternary digit is -1
THEN IF the next less significant ternary digit is X or -1
THEN the output bit is 0
ELSE the output bit is 1.

9. Signal processing apparatus according to Claim 7 or Claim 8 further comprising input loading means for receiving a plurality of numbers in binary format and for affording the numbers to a plurality of latch circuits for storage therein, and enabling means for selectively enabling the inputs of the modified signed digit adder cells for effecting simultaneous addition and or subtraction of the numbers afforded thereto from the latch circuits.

10. Signal processing apparatus according to Claim 9 further comprising modulus correction means thereby to provide a modulo multiplier, the modulus correction means being coupled to the adder cells, arranged to examine an intermediate sum of the modulo multiplier, generated by addition of the numbers by the adder cells, and to compare the intermediate sum with a predetermined value and, when the intermediate sum exceeds the predetermined value, to decrement a modulus number M in binary format, or a multiple thereof, from the intermediate sum for providing modulus correction to the intermediate sum such that the bit length of the intermediate sum does not exceed a predetermined length thereby to evaluate, in accordance with numbers A, B and M afforded to the signal processing apparatus, the modulo multiplication of A and B
A*B modulo M.

11. Signal processing apparatus apparatus according to Claim 10 wherein the modulus correction means is arranged such that the intermediate sum, obtained after each addition of the numbers, is afforded to the input of the adder uncorrected such that, the modulus number M, or the multiple thereof, is decremented from the intermediate sum during the next add cycle of the adder, thereby to enable modulo addition of and modulus correction to the modified signed digit format intermediate sum in a single clock cycle of the signal processing apparatus.

12. Signal processing apparatus according to Claim 11 wherein the modulus correction provided to the intermediate sum comprise $2^n \times M$ where n is an integer.

13. Signal processing apparatus according to Claim 11 or Claim 12 wherein the modulus correction means includes means for examining a selected consecutive number of the most significant ternary digits of the modified signed digit format intermediate sum for providing an approximate evaluation of the intermediate sum, and for examining a selected consecutive number of the most significant bits of the modulus number M for providing an approximate evaluation of the number M, thereby to optimise the modulus correction provided to the intermediate sum.

14. Signal processing apparatus according to Claim 13 wherein the modulus correction means is arranged to operate in accordance with the following algorithm.

```
IF          S6 < 12 * M4   THEN leave S unchanged

ELSE  IF  S6 < 20 * M4   THEN subtract  8 x M from S

        ELSE                      subtract 16 x M from S
```

where S6 is the evaluation of the modified signed digit format intermediate sum composed of the six most significant ternary digits, followed by zeros, of the intermediate sum;
M4 is the evaluation of the binary number M composed of the four most significant bits, followed by zeros, of the number M; and
S is the intermediate sum.

15. A method of processing signals comprising affording binary coded modified signed digit format signals and binary coded signals to a modified signed digit adder cell thereby to effect simultaneous addition and or substraction of the afforded signals.

16. A method according to Claim 15 wherein the binary coded modified signed digit format signals have their ternary digits 1, 0 and -1 represented by a two bit binary code and wherein the binary coded modified signed digit format signals are afforded to input lines of a first input of the modified signed digit adder cell and a bit of the binary coded signal is provided to a first and or further input line of a further input of the modified signed digit adder cell thereby to effect the simultaneous addition and or subtraction of the binary signals and the binary coded modified signed digit signals.

17. A method according to Claim 16 wherein the bit of the binary coded signal is afforded to the first input line of the further input of the modified signed digit adder cell and a binary zero is afforded to the further input line of the further input of the modified signed digit adder cell thereby to effect simultaneous addition of the binary coded signal and the binary coded modified signed digit signal.

18. A method according to Claim 16 wherein the bit of the binary coded signal is afforded to the further input line of the further input of the modified signed digit adder cell and a binary zero is afforded to the first input line of the further input of the modified signed digit adder cell thereby to effect simultaneous subtraction of the binary coded signal from the binary coded modified signed digit format signal.

19. A method according to Claim 16 wherein a bit of a first binary coded signal is afforded to the first input line of the further input of the modified signed digit adder cell and a bit of a further binary coded signal is afforded to the further input line of the further input of the modified signed digit adder cell and, when the bits of the first and further binary coded binary signals applied to the further input comprise the two bit binary code not used to represent a ternary digit of the binary coded modified signed digit signals, processing the bits applied to the input lines of the further input as a binary zero, thereby to effect simultaneously, addition of one binary coded signal to, and subtraction of the other binary coded signal from, the binary coded modified signed digit signals.

7

20. A method according to any one of Claims 15 to 19 wherein the results of the simultaneous addition and or subtraction of the binary coded signals and binary coded modified signed digit format signals, in modified signed digit format, are converted into binary coded signals.

21. A method according to any one of Claims 15 to 20 wherein an intermediate sum of a modulo multiplier arising from the addition of two signals representing two numbers applied to a modified signed digit adder comprising a plurality of modified signed digit adder cells, is compared with a predetermined value and, when the intermediate sum exceeds the predetermined value, a modulus number M in binary format, or a multiple thereof, is subtracted from the intermediate sum thereby to apply modulus correction to the intermediate sum.

22. A method according to Claim 21 wherein the subtraction of the modulus number M, or the multiple thereof, is delayed by one clock cycle of the modified signed digit adder cell thereby to effect modulo addition of the two numbers and modulus correction thereto in a single clock cycle of the modified signed digit adder.

23. A method according to Claim 21 or 22 wherein a selected consecutive number of the most significant ternary digits of the intermediate sum are examined so as to provide an approximate evaluation of the intermediate sum, and a selected consecutive number of the most significant bits of the modulus number M are examined so as to provide an approximate evalaution of the modulus number, thereby to maximise the modulus correction applied to the intermediate sum.

24. RSA encryption and or decryption apparatus comprising signal processing apparatus according to any one of Claims 1 to 14 or arranged to operate in accordance with any one of Claims 1 to 23.

T AND W

T' AND W'

$i = 1$ TO $n$

$w'_{n-1} = t_{n-1}$

$t'_0 = w_0$

T

$z_i$

FIG.1

FIG. 2

FIG.3

EP 0 353 041 A2

FIG.4

FIG.5

FIG.6

FIG.7